(19) **Europäisches Patentamt / European Patent Office / Office européen des brevets**

(11) **EP 4 580 047 A1**

(12) **DEMANDE DE BREVET EUROPEEN**

(43) Date de publication:
**02.07.2025   Bulletin 2025/27**

(21) Numéro de dépôt: **24222697.5**

(22) Date de dépôt: **22.12.2024**

(51) Classification Internationale des Brevets (IPC):
**H03B 17/00** *(2006.01)*     **H03B 5/04** *(2006.01)*

(52) Classification Coopérative des Brevets (CPC):
**H03B 17/00; H03B 5/04**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité:   **23.12.2023   FR 2315254**

(71) Demandeur: **Commissariat à l'Energie Atomique et aux Energies Alternatives**
**75015 Paris (FR)**

(72) Inventeurs:
• **FURCATTE, Thomas**
  **38054 GRENOBLE CEDEX 09 (FR)**
• **SANSA PERNA, Marc**
  **38054 GRENOBLE CEDEX 09 (FR)**

(74) Mandataire: **INNOV-GROUP**
**209 Avenue Berthelot**
**69007 Lyon (FR)**

(54) **OSCILLATEUR OPTO - MÉCANIQUE STABILISÉ EN TEMPÉRATURE**

(57)     Oscillateur optomécanique, comportant :
- une première source de lumière laser (11), émettant un premier faisceau de lumière ($F_1$) à une première longueur d'onde ($\lambda_1$) ;
- un résonateur (30) configuré pour osciller selon une fréquence de résonance ($f_r$), optiquement couplé au premier faisceau de lumière, de façon que le résonateur collecte une fraction de la lumière se propageant dans le premier faisceau, ladite fraction de lumière étant modulée selon la fréquence de résonance;

- un circuit de traitement (40), configuré pour :
• recevoir, en une entrée, le premier faisceau de lumière s'étant propagé le long du résonateur(30) ;
• adresser un signal de rétroaction (Sr) destiné à alimenter le résonateur ;
• former, en une sortie, un signal de sortie ($S_{out}$), modulé en amplitude, à une fréquence de modulation stabilisée.

EP 4 580 047 A1

**Fig. 3A**

**Description**

## DOMAINE TECHNIQUE

Le domaine technique de l'invention concerne les oscillateurs opto-mécaniques.

## ART ANTERIEUR

Le recours à un oscillateur optomécanique permet une formation d'un signal électronique périodique dont l'amplitude et la période sont maîtrisées. Une application possible est la formation d'un signal d'horloge.

Dans les dispositifs de l'art antérieur, les oscillateurs optomécaniques comportent une structure mécaniquement oscillante optiquement couplée à un faisceau de lumière. Sous l'effet du couplage optique, une partie de la lumière se propageant dans le guide d'onde est extraite mécaniquement Sous l'effet de l'oscillation mécanique, à une fréquence de résonance, l'efficacité du couplage optique varie à la fréquence de résonance. Il en résulte une variation périodique de la quantité de lumière se propageant dans le guide d'onde.

La publication Xu et al « Ultra-sensitive chip-based photonic température sensor using ring resonator structures" décrit une cavité optique, couplée à un guide d'onde rectiligne. La cavité est en forme d'anneau. Elle est optiquement couplée au guide d'onde rectiligne, par couplage évanescent. Sous l'effet d'une variation de température, la longueur d'onde de résonance optique est modifiée. Ainsi, une augmentation de la température entraîne une augmentation de la longueur d'onde de résonance. Le faisceau se propageant dans le guide d'onde rectiligne est un faisceau sonde. Les fluctuations de la puissance lumineuse transmise par le faisceau sonde, qui dépendent de la fréquence de résonnance, sont utilisées pour déterminer la variation de température de la structure résonnante. Le dispositif décrit dans la publication forme ainsi un thermomètre photonique.

La publication Lee et al « Low jitter and température stable MEMS oscillators" décrit un oscillateur électromécanique comportant une thermistance d'une structure oscillante. La température résultant de la thermistance est utilisée pour corriger électroniquement un signal modulé par la structure oscillante. Cependant, le thermistor est séparé de la structure oscillante : la température qu'il mesure peut-être différente de la température au sein même de la structure oscillante.

La publication Huang et al. 2017. "Direct stabilization of optomechanical oscillators" décrit un oscillateur optomécanique fonctionnant dans un régime dans lequel un changement de température induit une perturbation de la fréquence de résonance mécanique, mais également une modification de l'amplitude d'oscillation. L'oscillateur est asservi en maintenant constante l'amplitude d'oscillation, ce qui joue indirectement un rôle sur la stabilité fréquentielle.

La publication Gavartin 2013 "Stabilization of a linear nanomechanical oscillator to its thermodynamic limit" décrit un résonateur fonctionnant selon deux fréquences mécaniques différentes. L'actionnement est dit multimode. La dérive fréquentielle d'un premier mode sert à compenser celle du deuxième mode. Néanmoins, cette alternative n'est possible qu'en ayant recours à d'autres oscillateurs ultra stables. Cette configuration est envisageable pour des applications de capteurs, mais pas pour des bases de temps

Les inventeurs proposent un oscillateur optomécanique permettant une meilleure prise en compte de la variation de température. L'objectif peut être de générer un signal modulé en amplitude dont la puissance et la période sont stables.

## EXPOSE DE L'INVENTION

Un objet de l'invention est oscillateur optomécanique, comportant :

- une première source de lumière laser, émettant un premier faisceau de lumière à une première longueur d'onde;
- un résonateur configuré pour osciller selon une fréquence de résonance, le résonateur étant configuré pour être optiquement couplé au premier faisceau de lumière, selon une première bande passante de couplage comprenant la première la longueur d'onde, de façon que le résonateur collecte une fraction de la lumière se propageant dans le premier faisceau, ladite fraction de lumière étant modulée selon la fréquence de résonance;
- un circuit de traitement, configuré pour :

  • recevoir, en une entrée, le premier faisceau de lumière s'étant propagé le long du résonateur;
  • adresser un signal de rétroaction destiné à alimenter le résonateur ;
  • former, en une sortie, un signal de sortie modulé en amplitude, à une fréquence de modulation correspondant à la fréquence de résonance;

  l'oscillateur étant caractérisé en ce que le circuit de traitement, comporte :

  - un circuit de photodétection, formant l'entrée du circuit de traitement, et configuré pour détecter au moins une première partie du premier faisceau de lumière de façon à former

  un signal de détection modulé en fréquence à la fréquence de résonance, le circuit de traitement étant configuré pour former le signal de sortie en fonction du signal de détection ;

  - un filtre passe bas, relié au circuit de photodétection, configuré pour former un signal de correction, à une fréquence inférieure à la fréquence de résonance, le signal de correction étant représentatif d'une variation de température du résonateur ;

- un correcteur, relié au filtre passe-bas et configuré pour corriger la fréquence de modulation du signal de détection en fonction du signal de correction.

Selon un mode de réalisation, le circuit de photodétection comporte un premier photodétecteur, relié à :

- une branche de détection, portant le signal de détection ;
- une branche de correction, comportant le filtre passe bas et le correcteur.

Selon un mode de réalisation, le circuit de photodétection comporte :

- un premier photodétecteur, débouchant sur une branche de détection, portant le signal de détection ;
- un deuxième détecteur, débouchant sur une branche de correction, la branche de correction comportant le filtre passe bas et le correcteur.

Le correcteur peut être configuré pour appliquer le signal de correction :

- au signal de détection, résultant du premier photodétecteur ;
- ou au résonateur;
- ou à la première source de lumière.

Selon une possibilité, le correcteur est configuré pour :

- estimer une variation de la fréquence de résonance en fonction du signal de correction ;
- corriger une fréquence du signal de détection résultant du premier photodétecteur, en fonction de la variation de la fréquence de résonance estimée.

Le correcteur peut être configuré pour appliquer une fonction de réponse au signal de correction pour estimer la variation de fréquence de résonance

Selon une possibilité, le correcteur est relié à la première source de lumière laser, de façon à modifier une puissance d'émission du premier faisceau lumineux en fonction du signal de correction.

Selon une possibilité, le correcteur est relié au résonateur, de façon à modifier la fréquence de résonance en fonction du signal de correction.

Selon une possibilité, le résonateur comporte une unité de régulation, configurée pour être alimentée par le correcteur, de façon à ajuster la fréquence de résonance, par effet thermique ou électrostatique.

Selon une possibilité, le deuxième photodétecteur est configuré pour détecter une deuxième partie du premier faisceau lumineux s'étant propagé à travers le guide d'onde.

Selon une possibilité, le guide d'onde est configuré pour recevoir le premier faisceau de lumière et propager ce dernier le long du résonateur, vers le circuit de traitement.

Selon une possibilité, l'oscillateur comporte :

- une deuxième source de lumière laser, émettant un deuxième faisceau de lumière à une deuxième longueur d'onde, différente de la première longueur d'onde, l'oscillateur étant tel que :
- le circuit de traitement est configuré pour recevoir le deuxième faisceau laser s'étant propagé le long du résonateur ;
- la deuxième longueur d'onde est comprise dans une deuxième bande passante de couplage du résonateur, de façon que le résonateur collecte une fraction de la lumière se propageant dans le deuxième faisceau, ladite fraction de lumière étant modulée selon la fréquence de résonance;
- le deuxième photodétecteur est configuré pour détecter tout ou partie du deuxième faisceau lumineux s'étant propagé le long du résonateur, de façon que le signal de correction est établi à partir d'une composante basse fréquence du deuxième faisceau lumineux.

Le circuit de traitement peut comporter un séparateur configuré pour :

- diriger tout ou partie du premier faisceau vers le premier photodétecteur ;
- diriger tout ou partie du deuxième faisceau vers le deuxième photodétecteur.

L'oscillateur peut comporter:

- une voie optique, s'étendant entre la deuxième source de lumière et le circuit de traitement; la voie optique étant configurée pour transporter une partie du deuxième faisceau de lumière de la source de lumière vers le circuit de traitement;
- un interféromètre, configuré pour former un signal d'interférence entre :

  • le deuxième faisceau s'étant propagé le long du résonateur ;
  • la partie du deuxième faisceau de lumière débouchant de la voie optique ;

- le circuit de traitement étant tel que le deuxième photodétecteur est configuré pour détecter le signal d'interférence résultant de l'interféromètre .

Le guide d'onde peut être configuré pour recevoir le deuxième faisceau de lumière et propager ce dernier le long du résonateur, vers le circuit de traitement.

L'oscillateur peut être peut comporter un filtre passe haut, disposé entre le premier photodétecteur et le résonateur, et dont la fréquence de coupure est inférieure ou égale à la fréquence de résonance.

L'invention sera mieux comprise à la lecture de l'exposé des exemples de réalisation présentés, dans la suite de la description, en lien avec les figures listées ci-dessous.

## FIGURES

La figure 1A et la figure 1B schématisent un guide d'onde et un résonateur optomécanique, formant un oscillateur optomécanique

La figure 2A illustre le décalage harmonique de la bande passante de couplage optique, sous l'effet d'une oscillation mécanique, générant une oscillation de puissance optique délivrée par l'oscillateur tel que décrit en lien avec les figures 1A et 1B

La figure 2B illustre un effet d'une variation de température sur la puissance optique délivrée par l'oscillateur mécanique.

La figure 3A schématise un premier mode de réalisation de l'invention.

La figure 3B schématise une variante du premier mode de réalisation de l'invention.

La figure 3C schématise une autre variante du premier mode de réalisation de l'invention.

La figure 3D montre une autre variante du premier mode de réalisation de l'invention.

La figure 4 illustre deux bandes passantes de couplage optique adressées par deux longueurs d'onde différentes.

La figure 5A schématise un deuxième mode de réalisation de l'invention.

La figure 5B schématise une variante du deuxième mode de réalisation de l'invention.

La figure 5C schématise une autre variante du deuxième mode de réalisation de l'invention.

La figure 5D schématise une autre variante du deuxième mode de réalisation de l'invention.

## EXPOSE DE MODES DE REALISATION PARTICULIERS

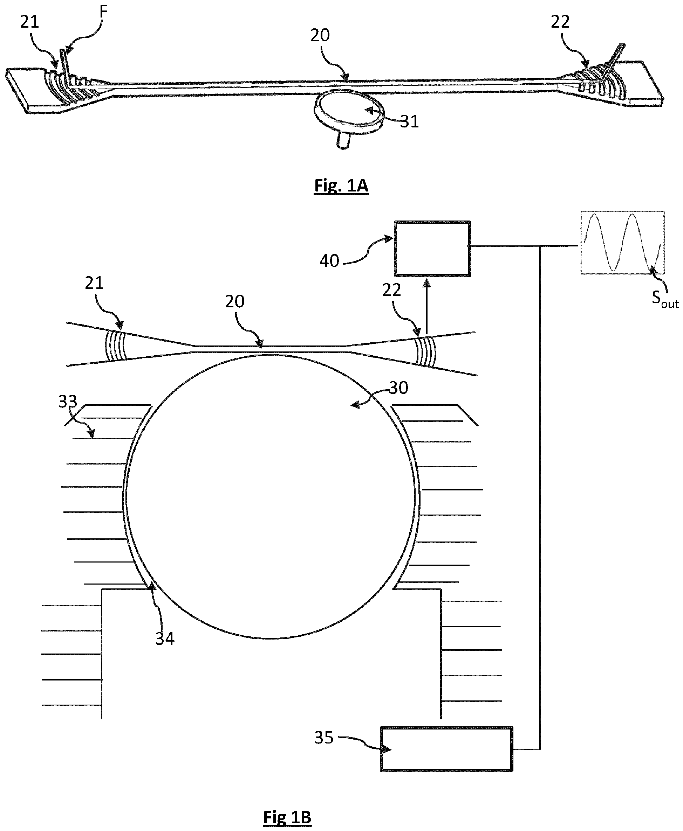

Les figures 1A et 1B schématisent un exemple d'oscillateur optomécanique. L'oscillateur comporte un guide d'onde 20 configuré pour guider un faisceau lumineux F. Le guide d'onde 20 s'étend entre un premier coupleur optique 21 et un deuxième coupleur optique 22. Le premier coupleur optique 21 est configuré pour permettre l'admission d'un faisceau lumineux, en particulier un faisceau laser, dans le guide d'onde de puissance. Le faisceau lumineux est produit par une source laser 10. Le deuxième coupleur optique 22 est configuré pour permettre une extraction de la lumière s'étant propagée dans le guide d'onde 20. Les premier et deuxième coupleurs optiques sont par exemple des réseaux de diffraction, ce type de structure étant connue de l'homme du métier.

L'oscillateur comporte un résonateur 30 s'étendant le long du guide d'onde 20, entre le premier coupleur 21 et le deuxième coupleur 22. Le résonateur 30 est configuré pour osciller à une fréquence de résonance $f_r$. Le résonateur 30 est, dans cet exemple, une structure pouvant être animée d'un mouvement planaire, dit mode de contour, selon la fréquence de résonance, sous l'effet d'un actionnement électrostatique conféré par un actuateur 33. L'actuateur 33, représenté sur la figure 1B, est fixe par rapport au résonateur 30. L'actuateur 33 est situé de part et d'autre du résonateur 30. L'actionnement électrostatique est effectué à travers un entrefer 34, s'étendant entre l'actuateur 33 et le résonateur 30. L'actionnement électrostatique est commandé par une unité de commande 35.

Le guide d'onde 20 peut être réalisé sur la couche de Si superficielle d'un substrat de type SOI (silicon on Insulator - silicium sur isolant). La section transversale peut par exemple être de quelques centaines de nm par quelques centaines de nm, par exemple de l'ordre de 600 nm x 200 nm. Par section transversale, on entend une section dans un plan perpendiculaire à l'axe de propagation de la lumière dans le guide d'onde. De préférence, le guide d'onde 20 est configuré pour effectuer une propagation selon un seul mode, à une longueur d'onde qui peut être 1550 nm, longueur d'onde usuelle dans le domaine des télécommunications.

Le résonateur peut avoir un diamètre de l'ordre de 10 $\mu$m, une épaisseur de l'ordre de 220 nm. La dimension de l'entrefer 34 est par exemple de l'ordre de 100 nm.

Le résonateur 30 est optiquement couplé au guide d'onde 20, par exemple par couplage évanescent. La distance minimale entre le résonateur 30 et le guide d'onde 20 est par exemple de 60 nm, et typiquement comprise entre 100 et 150 nm. Ainsi, lorsqu'un faisceau lumineux se propage le long du guide d'onde 20, une partie du faisceau lumineux est extraite et se propage dans et autour du résonateur 30, ou en champ proche autour de ce dernier.

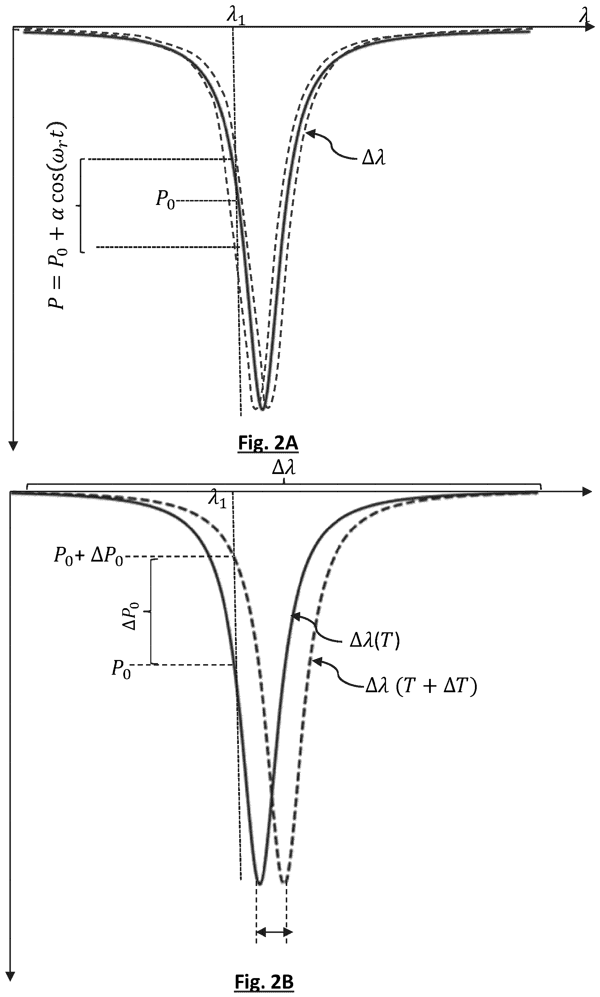

L'oscillateur comporte un circuit de traitement 40, destiné à produire un signal de sortie $S_{out}$ modulé en amplitude, selon une fréquence de modulation la plus stable possible. Le circuit de traitement comporte une boucle de rétroaction, reliant le circuit de traitement 40 à l'unité de commande 35, de façon à entretenir l'oscillation du résonateur à la fréquence de résonance. La figure 2A illustre une bande passante de couplage optique entre le guide d'onde 20 et le résonateur 30. Par la suite, ce couplage est désigné couplage guide d'onde 20 / résonateur 30, de dernier formant une cavité optique. L'axe des abscisses correspond à la longueur d'onde optique. L'axe des ordonnées correspond à la puissance lumineuse extraite du guide d'onde 20 : cela représente la fraction de lumière collectée par le résonateur. La courbe en trait plein représente une configuration selon laquelle le résonateur est fixe. Sous l'effet de l'oscillation, le résonateur est déformé, ce qui se traduit par une modification du couplage optique guide d'onde 20 / résonateur 30. Sur la figure 2A, cela se traduit par un décalage périodique de la bande passante de couplage, entre les deux courbes en tirets, traduisant un décalage spectral du couplage optique guide d'onde 20 / résonateur 30. La bande passante de couplage peut également s'élargir ou se rétrécir, sans que la longueur d'onde centrale de la bande passante ne soit décalée.

Sur la figure 2A, la ligne verticale en pointillés correspond à la longueur d'onde $\lambda$ du faisceau F se propageant dans le guide d'onde 20. Sous l'effet de la variation périodique de la bande passante de couplage, la fraction de lumière optiquement couplée au résonateur varie. La puissance du faisceau optique F se propageant dans le guide d'onde est alors modulée selon une pulsation $\omega_r$ selon l'expression :

$$P = P_0 + \alpha \cos(\omega_r . t) \ (1)$$

où :

- $P_0$ correspond à une puissance, dite puissance statique, se propageant dans le guide d'onde « à l'équilibre », c'est-à-dire en l'absence d'oscillation du résonateur 30;
- $\alpha$ correspond l'amplitude de modulation ;
-

$$\omega_r = 2\pi f_r \ (2)$$

De préférence, la longueur d'onde $\lambda$ correspond à la partie la plus pentue de la courbe décrivant la bande passante de couplage $\Delta\lambda$. Cela permet de maximiser la variation de puissance extraite par le couplage optique par rapport à la variation périodique spectrale de la bande passante de couplage.

Comme décrit en lien avec l'art antérieur, sous l'effet d'une variation de la température $\Delta T$ du résonateur, la bande passante de couplage optique varie. Cela se traduit par un décalage spectral de la bande passante de couplage, schématisé sur la figure 2B. Ainsi, la puissance du faisceau se propageant dans le guide d'onde 20 est modulée temporellement, selon l'expression :

$$P = (P_0 + \Delta P_0) + \alpha \cos\big((\omega_r + \Delta\omega_r)t\big) \ (3)$$

où :

- $\Delta P_0$ traduit un décalage de la puissance, dite statique, se propageant à travers le guide d'onde, sous l'effet de la variation de température ;
- $\Delta\omega_r$ correspond à un décalage en pulsation traduisant le décalage en fréquence, de la modulation de puissance, sous l'effet de la variation de température $\Delta T$.

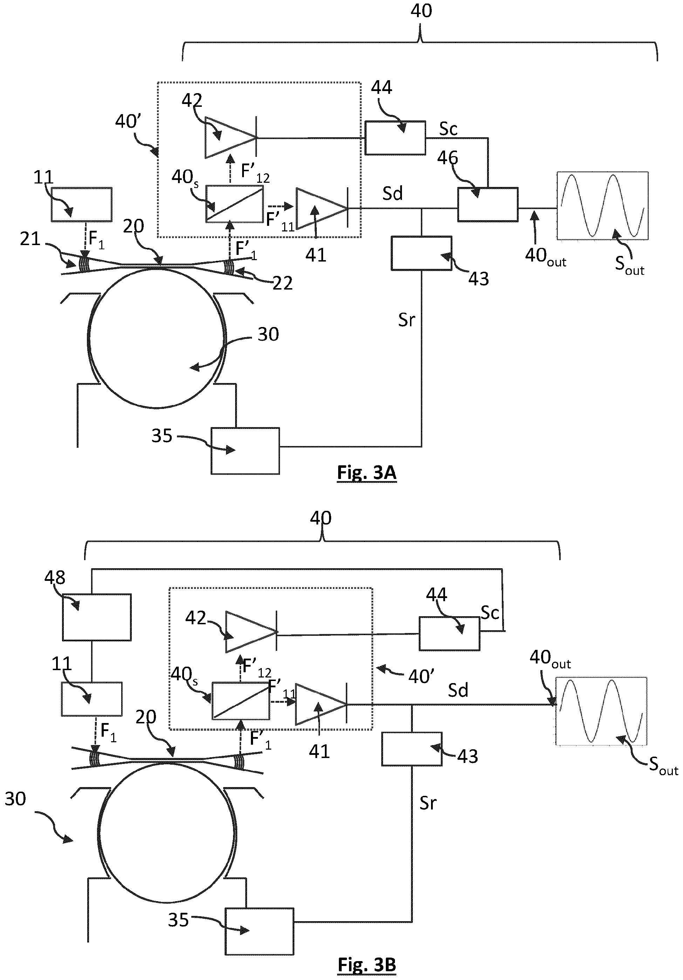

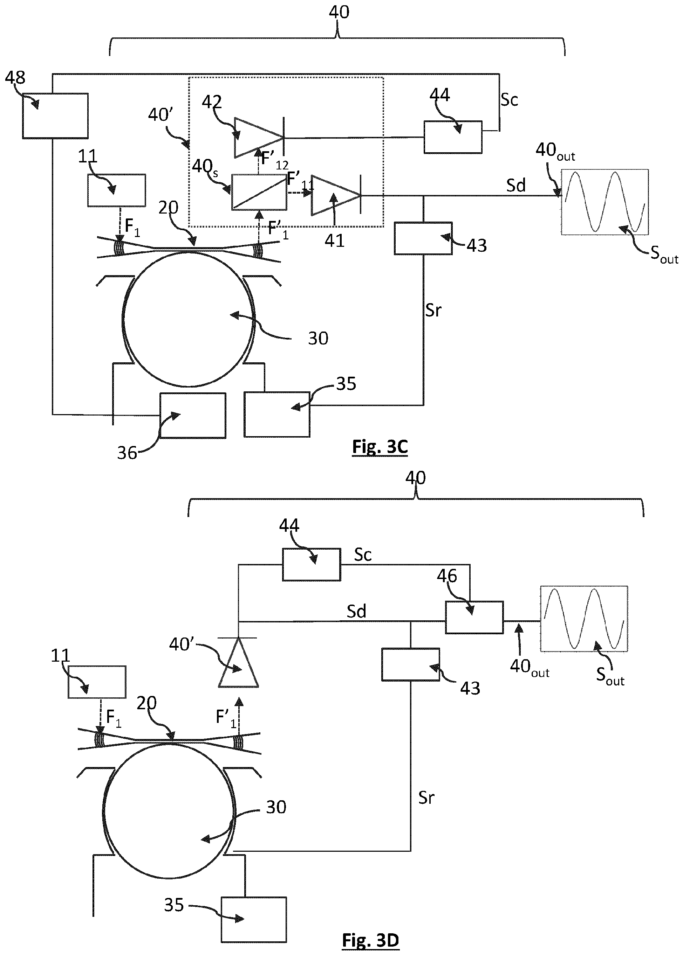

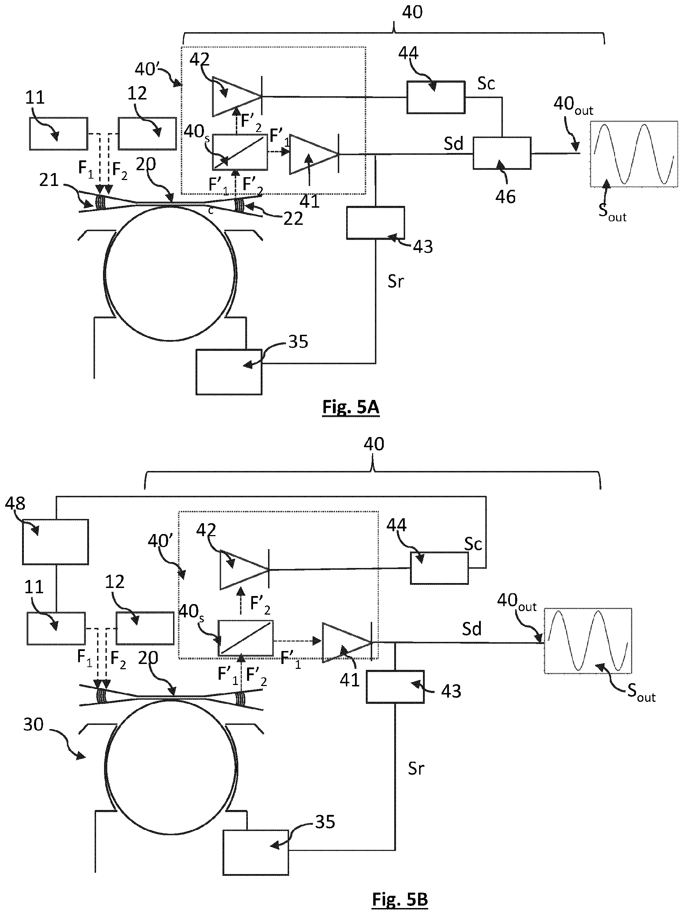

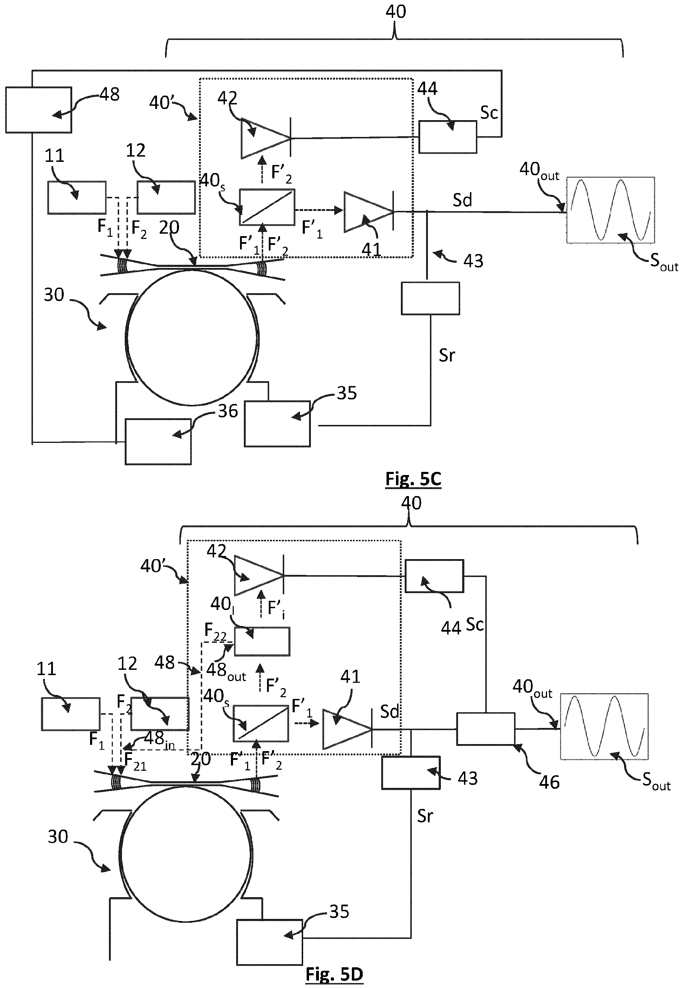

Les oscillateurs décrits ci-après, en lien avec les figures 3A, 3B, 3C, 3D, 5A, 5B, 5C, 5D, visent à apporter une correction pour corriger le décalage en fréquence, représenté ici par le décalage de la pulsation $\Delta\omega_r$.

Un premier mode de réalisation d'oscillateur stabilisé en température est représenté sur la figure 3A. L'oscillateur 1 comporte un guide d'onde 20 et un résonateur 30 tel que décrits en lien avec les figures 1A et 1B. Le dispositif comporte une première source laser 11, destinée à produire un premier faisceau lumineux $F_1$ destiné à être modulé en puissance par le résonateur 30. Le premier faisceau laser $F_1$ est couplé au guide d'onde 20 par le premier coupleur 21. Le premier faisceau lumineux est par exemple émis à une première longueur d'onde $\lambda_1$ comprise dans la bande spectrale 1520 nm - 1580 nm lorsque l'oscillateur est destiné à des applications de type télécommunications.

En aval du résonateur 30, tout ou partie du premier faisceau laser $F_1$ est extrait du guide d'onde 20 par le deuxième coupleur 22, pour former un faisceau extrait $F'_1$. Le faisceau extrait $F'_1$ est représentatif de la modulation en puissance effectuée par le résonateur 30. Le faisceau extrait $F'_1$ est dirigé vers un circuit de traitement 40. Comme précédemment décrit, le circuit de traitement 40 est configuré pour établir un signal de sortie $S_{out}$, périodique et modulé en intensité. Un aspect important du circuit de traitement 40 est qu'il est configuré pour que signal de sortie soit modulé en amplitude selon une fréquence de modulation la plus stable possible.

Quel que soit le mode de réalisation, e circuit de traitement 40 comporte une entrée formée par un circuit de photodétection 40'. Le circuit de photodétection comporte un photodétecteur ou plusieurs photodétecteurs, selon les modes de réalisation. Le circuit de traitement s'étend entre le circuit de photodétection 40' et une sortie, délivrant le signal de sortie $S_{ou}$.

Le faisceau extrait $F'_1$ est dirigé vers un séparateur $40_s$. Le séparateur $40_s$, usuellement désigné « power splitter », est configuré pour diriger :

- une première partie $F'_{11}$ du faisceau extrait $F'_1$ vers une première branche, dite branche de détection, destinée à former le signal de sortie $S_{out}$ et à former un signal de rétroaction Sr alimentant l'unité de commande 35 du résonateur 30.
- une deuxième partie $F'_{12}$ du faisceau extrait $F'_1$ vers une deuxième branche, dite branche de correction, destinée à générer un signal de correction Sc. Le signal de correction est représentatif d'une variation de la première bande spectrale de couplage en fonction de la variation de température. La branche de correction comporte, dans cet exemple, un deuxième photodétecteur 42, un filtre passe basse fréquence 44 et un correcteur 46.

La première partie F'$_{11}$ du faisceau extrait F'$_1$ est destinée à générer le signal de sortie S$_{out}$, modulé en amplitude. Elle peut représenter 50% de F'$_1$. De préférence, la première partie F'$_{11}$ est plus importante que la deuxième partie F'$_{12}$. La première partie F'$_{11}$ peut correspondre à au moins 80% ou au moins 90% du faisceau F'$_1$, la deuxième partie F'$_{12}$ correspondant à la portion complémentaire.

Dans cet exemple, le premier photodétecteur 41 est une photodiode. Le premier photodétecteur 41 génère un signal de détection Sd, de pulsation $(\omega_r + \Delta\omega_r)$, qui est une image du faisceau optique. Une partie du signal de détection Sd est dirigée vers l'unité de commande 35 du résonateur 30, et forme le signal de rétroaction Sr. La boucle de rétroaction comporte un filtre passe haut 43. Le filtre passe-haut 43 est configuré pour extraire une composante haute fréquence du signal de détection résultant du premier photodétecteur 41. Par composante haute fréquence, on entend une composante dans une plage de fréquences comportant la résonnance $f_r$ du résonateur 30.

Le deuxième photodétecteur 42 est par exemple une photodiode. Le filtre passe-bas 44 est configuré pour extraire une composante basse fréquence du signal résultant du deuxième photodétecteur, formant le signal de correction Sc. Par composante basse fréquence, on entend une composante strictement inférieure à la fréquence de résonnance $f_r$ du résonateur 30, par exemple à une fréquence inférieure à 100 Hz, voire à 10 Hz, voire à 1Hz. Cela permet d'estimer la composante basse fréquence, correspondant à la variation de l'amplitude de modulation $\Delta P_0$ sous l'effet de la dérive progressive de la bande passante de couplage $\Delta\lambda$ entre le guide d'onde 20 et le résonateur 30, sous l'effet d'une variation progressive de la température du résonateur 30. La composante basse fréquence, formant le signal de correction Sc, est représentative de la variation de puissance optique $\Delta P_0$. Elle dépend de la variation de température $dT$ du résonateur.

Le circuit de traitement 40 est configuré pour extraire le signal de correction Sc résultant du filtre passe bas 44, et pour corriger, à partir du signal de correction, le signal de détection Sd se propageant en aval du premier photodétecteur 41. Pour cela, le circuit de traitement comporte un composant de correction 46, alimenté par :

- le signal de correction Sc résultant du filtre passe bas 44;
- le signal de détection Sd résultant du photodétecteur 41, à partir duquel le circuit de traitement forme le signal de sortie S$_{out}$.

Le composant de correction 46 prend en compte une fonction de transfert $h$, préétablie, reliant la dérive basse fréquence, correspondant à la variation de la puissance statique $\Delta P_0$ , sous l'effet de la température, à la dérive haute fréquence, correspondant à la variation de la fréquence de modulation. Le composant de correction peut comporter une partie numérique, permettant l'estimation de $\Delta\omega_r$ et sa prise en compte pour corriger la pulsation du signal de détection.

La fonction de transfert permet d'estimer $\Delta\omega_r$ en fonction de $\Delta P_0$ : $\Delta\omega_r = h(Sc)$, sachant que le signal de correction Sc correspond à $\Delta P_0$ : le signal de correction Sc est représentatif de la variation de température sur $\Delta P_0$.

Par exemple, on peut se placer dans une hypothèse simplificatrice selon laquelle la fréquence dérive linéairement avec la température : $\Delta\omega_r = \gamma\Delta T$ où $\gamma$ est un coefficient positif connu. Le coefficient $\gamma$ peut être déterminé par modélisation et/ou de façon expérimentale. On suppose également que la variation de puissance optique $\Delta P_0$ est également une fonction linéaire de la température : $\Delta P_0 = \beta\Delta T$. $\beta$ est un coefficient positif connu. Le coefficient $\beta$ peut être déterminé par modélisation et/ou de façon expérimentale.

Ainsi,

$$\Delta\omega_r = \gamma\frac{\Delta P_0}{\beta}.$$

Ce raisonnement peut être généralisé à des dépendances non linéaires de la fréquence et de la variation de puissance optique par rapport à la température. Par exemple, si $\Delta\omega_r = g_1(\Delta T)$ et $\Delta P_0 = g_2(\Delta T)$, $\Delta\omega_r = g_1(g_2^{-1}(\Delta P_0)) = h(\Delta P_0)$. Les fonctions $g_1$ et $g_2$ sont établies expérimentalement et/ou par modélisations. $h = g_1 \circ g_2^{-1}$

Ainsi, le correcteur 46 est configuré pour estimer $\Delta\omega_r$, à partir de $Sc$, et pour corriger la fréquence de modulation du signal de détection $sd$ en fonction de $\Delta\omega_r$. On obtient ainsi un signal de sortie S$_{out}$ modulé en amplitude et stabilisé sur la pulsation $\omega_r$.

Un avantage de l'oscillateur décrit en lien avec la figure 3A est que correction du signal de sortie est effectuée à partir du faisceau lumineux ayant été modulé en amplitude par le résonateur 30.

Cela permet une meilleure prise en compte de la variation de température qu'en effectuant une correction à partir d'une mesure externe de la température. Cet avantage se vérifie pour les autres configurations décrites par la suite.

La figure 3B représente une variante de l'oscillateur décrit en lien avec la figure 3A. Le circuit de traitement 40 comporte une branche de correction, similaire à celle décrite sur la figure 3A. Le circuit de traitement 40 comporte le photodétecteur 41 et le filtre passe-haut 43 et décrits en lien avec la figure 3A, formant la branche de détection. Une particularité de cette variante est que la composante basse fréquence, formant le signal de correction Sc, n'est pas utilisée directement pour estimer la dérive de la fréquence de modulation, mais pour alimenter un composant de correction 48, ce dernier étant configuré pour moduler l'alimentation du laser 11.

Ainsi, la puissance du laser peut être réduite, lorsque la température augmente, de façon à entraîner une baisse de la température. Le signal de correction Sc est utilisé pour rétroagir sur l'alimentation du laser 11.

La figure 3C représente une variante de l'oscillateur décrit en lien avec la figure 3B. Selon cette variante, le circuit de traitement 40 comporte une branche de correction, similaire à celle décrite sur la figure 3A. Le circuit de traitement 40 comporte le photodétecteur 41 et le filtre passe-haut 43 et décrits en lien avec la figure 3A, formant la branche de détection. Le signal de correction Sc est utilisé pour rétroagir sur le résonateur 30, par l'intermédiaire du correcteur 48, agissant sur une unité de régulation 36. L'unité de régulation 36 peut comporter une résistance, permettant de moduler la température a proximité du résonateur, ou une électrode face à l'entrefer 34, de façon à moduler la rigidité du résonateur 30, par effet électrostatique, usuellement désigné « electrostatic tuning ». Dans cette variante, le signal de correction Sc est configuré pour rétroagir directement sur le résonateur 30.

La figure 3D montre une variante de la configuration décrite en lien avec la figure 3A, dans laquelle le circuit de photodétection 40' comporte un seul photodétecteur 41, alimentant à la fois la branche de correction, qui comporte le filtre passe-bas 44 relié au correcteur 46, et la branche de détection, qui porte le signal de détection, destiné à former le signal de sortie. On comprend que le recours à un circuit de photodétection 40' ne comportant qu'un seul photodétecteur peut être transposée aux configurations décrites en lien avec les figures 3B et 3C.

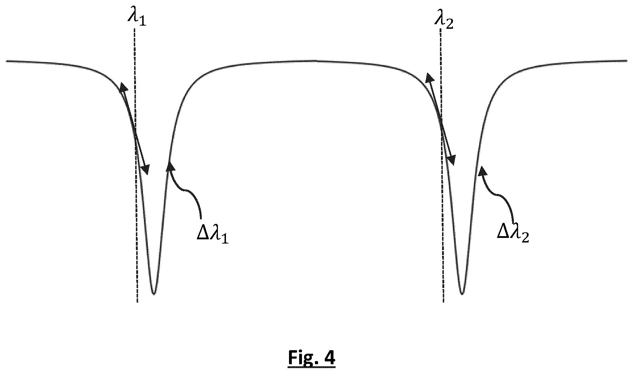

La figure 4 illustre une bande spectrale de couplage $\Delta\lambda$ comportant une succession de différentes bandes passantes élémentaires, sans chevauchement. On a représenté une première longueur d'onde $\lambda_1$ dans une première bande passante $\Delta\lambda_1$ et deuxième première longueur d'onde $\lambda_2$ dans une deuxième bande passante $\Delta\lambda_2$. Sur la figure 4, chaque pente a été matérialisée par une double flèche.

Les figures 5A à 5D concernent un mode de réalisation dans lequel l'oscillateur comporte deux sources de lumière différentes : une première source de lumière 11, telle que précédemment décrite, et une deuxième source de lumière 12, émettant un deuxième faisceau $F_2$, de préférence un faisceau laser, à une deuxième longueur d'onde $\lambda_2$, différente de la première longueur d'onde $\lambda_1$, comme décrit en lien avec la figure 4. Ainsi, une fluctuation de la bande passante de couplage à une longueur d'onde peut être utilisée pour déterminer la fluctuation de la bande spectrale de couplage à l'autre longueur d'onde.

La deuxième longueur d'onde est suffisamment décalée de la première longueur d'onde de façon que les deux longueurs d'onde puissent être spectralement séparées par un séparateur spectral usuel. Par exemple, le décalage spectral est supérieur à 1 nm et inférieur à 100 nm. Le décalage spectral est de préférence suffisamment faible pour permettre un couplage dans le guide d'onde 20 avec le premier coupleur et une extraction vers le circuit de traitement 40 à l'aide du deuxième coupleur.

Dans les exemples représentés sur les figures 5A à 5D, les faisceaux $F_1$ et $F_2$ sont introduits dans le guide d'onde 20 au niveau du premier coupleur 21. Ils sont extraits du guide d'onde 20 par le deuxième coupleur 22. Selon d'autres possibilités :

- on dispose de deux premiers coupleurs 21, adressant respectivement le premier faisceau $F_1$ et le deuxième faisceau $F_2$ ;
- et/ou on dispose de deux deuxièmes coupleurs 22, permettant l'extraction séparée du premier faisceau $F_1$ et du deuxième faisceau $F_2$.

Le deuxième faisceau laser $F_2$ fait office de faisceau sonde. Aussi, la puissance optique $P_2$ du deuxième faisceau $F_2$ est de préférence inférieure à la puissance optique $P_1$ du premier faisceau $F_1$. On peut avoir $P_2 \le 0.5\, P_1$ ou encore $P_2 \le 0.01\, P_1$. Il est préférable que le faisceau sonde travaille à faible intensité pour éviter le phénomène d'auto échauffement. Le faisceau $F_1$ travaille à haute puissance afin de pouvoir générer une modulation d'amplitude plus importante.

Sous l'effet d'une variation de température, la puissance du deuxième faisceau se propageant dans le guide d'onde est modulée temporellement selon l'expression :

$$P' = (P'_0 + \Delta P'_0) + \alpha \cos\big((\omega_r + \Delta\omega_r)t\big)\,(3')$$

où

- $\Delta P'_0$ traduit un décalage de la puissance statique se propageant à travers le guide d'onde, sous l'effet de la variation de température ;
- $\Delta\omega_r$ correspond au décalage en pulsation traduisant le décalage en fréquence, de la modulation de puissance, sous l'effet de la variation de température

Le mode de réalisation décrit sur les figures 5A à 5D est basé sur une extraction du premier faisceau $F_1$, de façon à former un premier faisceau extrait $F'_1$, et une deuxième extraction du deuxième faisceau $F_2$, de façon à former un deuxième faisceau extrait $F'_2$. Le deuxième faisceau extrait $F'_2$ est destiné à mesurer la dérive basse fréquence $\Delta P'_0$, de la modulation du deuxième faisceau optique, de façon à estimer la variation de température. Le premier faisceau extrait $F'_1$ est destiné à former un signal de détection Sd, ce dernier étant utilisé pour rétroagir sur le résonateur 30 et pour former le signal de sortie $S_{out}$.

Dans les exemples décrits sur les figures 5A à 5D, les premier et deuxième faisceaux sont extraits au niveau du même deuxième coupleur 22. le circuit de photodétection 40' comporte deux photodétecteurs 41 et 42. Le circuit de traitement 40 comporte un séparateur $40_s$ configuré pour permettre une séparation spectrale des faisceaux extraits F'$_1$ et F'$_2$. Le faisceau extrait F'$_1$, à la longueur d'onde $\lambda_1$, est dirigé vers le premier photodétecteur 41 du circuit de traitement 40. Le faisceau extrait F'$_2$, à la longueur d'onde $\lambda_2$, est dirigé vers le deuxième photodétecteur 42 du circuit de traitement.

De même que dans les modes de réalisation représentés sur les figures 3A à 3C, circuit de traitement comporte avantageusement un filtre passe-haut 43 disposé dans la boucle de rétroaction alimentant le résonateur 30.

Le circuit de traitement 40 comporte un deuxième photodétecteur 42, par exemple de type photodiode, relié à un filtre passe bas 44. Le filtre passe bas 44 est destiné à extraire une composante basse fréquence du signal résultant du photodétecteur 42, considérée représentative de la variation de puissance optique $\Delta P'_0$, et formant le signal de correction Sc.

Dans le mode de réalisation représenté sur la figure 5A, le circuit de traitement comporte un composant de correction 46, alimenté par :

- le signal de correction Sc résultant du filtre passe bas 44 : le signal de correction correspond à la variation de puissance statique dans la deuxième bande spectrale. Ainsi, le signal de est représentatif d'une variation de la température du résonateur.
- le signal de détection Sd résultant du photodétecteur 41.

Le composant de correction 46 prend en compte une fonction de réponse h', préétablie, reliant la dérive basse fréquence, correspondant à la variation de la puissance statique $\Delta P'_0$ du deuxième faisceau, sous l'effet de la température, à la dérive haute fréquence, correspondant à la variation de la fréquence de modulation.

La fonction de réponse permet d'estimer $\Delta \omega_r$ en fonction de $\Delta P'_0$ : $\Delta \omega_r = h'(Sc)$, sachant que Sc correspond à $\Delta P'_0$, qui est représentative de $\Delta T$.

Ainsi, le correcteur 46 est configuré pour estimer $\Delta \omega_r$, à partir du signal de correction Sc , et pour corriger la fréquence de modulation du signal de détection Sd en fonction de $\Delta \omega_r$. On obtient ainsi un signal de sortie modulé en amplitude et stabilisé sur la pulsation $\omega_r$.

La figure 5B représente une variante de l'oscillateur décrit en lien avec la figure 5A. Le circuit de traitement 40 comporte un photodétecteur 42 et un filtre passe bas 44, tels que décrits sur la figure 5A, générant un signal de correction Sc. Le circuit de traitement comporte le photodétecteur 41 et le filtre passe haut 43 et décrits en lien avec la figure 5A. Le signal de correction Sc n'est pas utilisé directement pour estimer la dérive de la fréquence de modulation, mais pour moduler l'alimentation du laser 11, à travers un composant de correction 48 régulant cette dernière. Ainsi, la puissance du laser peut être réduite, lorsque la température augmente, de façon à entraîner une régulation de la température.

La figure 5C représente une variante de l'oscillateur décrit en lien avec la figure 5B. Selon cette variante, le circuit de traitement 40 comporte un photodétecteur 42 et un filtre passe bas 44, similaire à celle décrite sur la figure 5A. Le circuit de traitement 40 comporte le photodétecteur 41 et le filtre passe haut 43 et décrits en lien avec la figure 5A. Le signal de correction Sc est utilisé pour rétroagir sur le résonateur 30, comme décrit en lien avec la figure 3C. Le signal de correction est adressé, via un composant de correction, vers une unité de régulation 36, par exemple une résistance, permettant de moduler la température a proximité du résonateur, ou une électrode, face à l'entrefer, de façon à moduler la rigidification du résonateur 30, par effet électrostatique, usuellement désigné « electrostatic tuning ». Dans cette variante, le signal de correction est configuré pour rétroagir directement sur le résonateur 30.

Sur la figure 5D, on a représenté une variante du mode de réalisation décrit en lien avec la figure 5C. Sur la figure 5D, le circuit électronique d'analyse 40 comporte un interféromètre 40i, configuré pour permettre une interférence entre :

- une partie F$_{22}$ du faisceau F2, prélevée entre la deuxième source de lumière 12 et le guide d'onde 20 ;
- le faisceau F'2 extrait du guide d'onde 20.

Les faisceaux F$_2$ et F'$_2$ sont à la même longueur d'onde $\lambda_2$. Ils sont combinés dans l'interféromètre 40$_i$ de façon à former un signal d'interférence F'$_i$. Ce dernier est dirigé vers la branche basse fréquence du circuit de traitement. Le signal d'interférence F'$_i$ est représentatif d'un déphasage entre les faisceaux F$_2$ et F'$_2$. Il est considéré qu'une mesure d'une variation de phase est plus sensible qu'une mesure d'une variation de puissance.

Le recours à un interféromètre 40$_i$, tel que décrit sur la figure 5D, est compatible avec les modes de réalisation décrits sur les figures 5A à 5C.

L'invention permet de générer un signal de sortie S$_{out}$ modulé en amplitude, selon une fréquence stabilisée. Elle convient particulièrement à la formation d'un signal d'horloge, destiné à des circuits électroniques.

**Revendications**

1. Oscillateur optomécanique, comportant :

   - une première source de lumière laser (11), émettant un premier faisceau de lumière (F$_1$) à une première longueur d'onde ($\lambda_1$) ;
   - un résonateur (30) configuré pour osciller selon une fréquence de résonance ($f_r$), le résonateur étant configuré pour être optiquement couplé au premier faisceau de lumière, selon une première bande passante de couplage comprenant la première la longueur d'onde, de façon que le résonateur collecte une fraction de la lumière se propageant dans le premier faisceau, ladite fraction de lumière étant modulée selon la fréquence de résonance;
- un circuit de traitement (40), configuré pour :

• recevoir, en une entrée, le premier faisceau de lumière s'étant propagé le long du résonateur(30) ;
• adresser un signal de rétroaction (Sr) destiné à alimenter le résonateur ;
• former, en une sortie, un signal de sortie ($S_{out}$) modulé en amplitude, à une fréquence de modulation correspondant à la fréquence de résonance;

l'oscillateur étant **caractérisé en ce que** le circuit de traitement, comporte :

- un circuit de photodétection (40'), formant l'entrée du circuit de traitement, et configuré pour détecter au moins une première partie ($F'_1$, $F'_{11}$) du premier faisceau de lumière de façon à former un signal de détection ($S_d$) modulé en fréquence à la fréquence de résonance, le circuit de traitement étant configuré pour former le signal de sortie en fonction du signal de détection ;
- un filtre passe bas (44), relié au circuit de photodétection, configuré pour former un signal de correction (Sc), à une fréquence inférieure à la fréquence de résonance, le signal de correction étant représentatif d'une variation de température du résonateur ;
- un correcteur (46, 48), relié au filtre passe-bas et configuré pour corriger une dérive de la fréquence de modulation du signal de détection en fonction du signal de correction.

2. Oscillateur selon la revendication 1, dans lequel le circuit de photodétection comporte un premier photodétecteur (41), relié à :

- une branche de détection, portant le signal de détection ;
- une branche de correction, comportant le filtre passe bas (44) et le correcteur (46, 48).

3. Oscillateur selon la revendication 1, dans lequel le circuit de photodétection comporte :

- un premier photodétecteur (41), débouchant sur une branche de détection, portant le signal de détection ;

- un deuxième détecteur (42), débouchant sur une branche de correction, la branche de correction comportant le filtre passe bas (44) et le correcteur (46, 48).

4. Oscillateur selon l'une quelconque des revendications précédentes, dans lequel le correcteur (46, 48) est configuré pour appliquer le signal de correction :

- au signal de détection (Sd), résultant du premier photodétecteur ;
- ou au résonateur (30);
- ou à la première source de lumière (11).

5. Oscillateur selon la revendication 4 dans lequel le correcteur (46) est configuré pour :

- estimer une variation de la fréquence de résonance ($\Delta\omega_r$) en fonction du signal de correction ;
- corriger une fréquence du signal de détection ($\omega_r + \Delta\omega_r$) résultant du premier photodétecteur, en fonction de la variation de la fréquence de résonance estimée ($\Delta\omega_r$).

6. Oscillateur selon la revendication 5, dans lequel le correcteur est configuré pour appliquer une fonction de réponse (*h*) au signal de correction pour estimer la variation de fréquence de résonance

7. Oscillateur selon la revendication 4 dans lequel le correcteur (48) est relié à la première source de lumière laser (11), de façon à modifier une puissance d'émission du premier faisceau lumineux en fonction du signal de correction.

8. Oscillateur selon la revendication 4 dans lequel le correcteur (48) est relié au résonateur (30), de façon à modifier la fréquence de résonance en fonction du signal de correction, le résonateur comportant une unité de régulation (36), configurée pour être alimentée par le correcteur (48) de façon à ajuster la fréquence de résonance, par effet thermique ou électrostatique.

9. Oscillateur selon l'une quelconque des revendications 3, ou 4 à 8, si référées à la revendication 3, dans lequel le deuxième photodétecteur (42) est configuré pour détecter une deuxième partie du premier faisceau lumineux ($F'_{12}$).

10. Oscillateur selon l'une quelconque des revendications précédentes, comportant un guide d'onde (20) configuré pour recevoir le premier faisceau de lumière et propager ce dernier le long du résonateur, vers le circuit de traitement.

11. Oscillateur selon l'une quelconque des revendications 4 à 10, si référées à la revendication 3, comportant

- une deuxième source de lumière laser (12), émettant un deuxième faisceau de lumière ($F_2$) à une deuxième longueur d'onde ($\lambda_2$), différente de la première longueur d'onde, l'oscillateur étant tel que :
- le circuit de traitement est configuré pour recevoir le deuxième faisceau laser s'étant propagé le long du résonateur ;
- la deuxième longueur d'onde est comprise dans une deuxième bande passante de couplage du résonateur, de façon que le résonateur collecte une fraction de la lumière se propageant dans le deuxième faisceau, ladite fraction de lumière étant modulée selon la fréquence de résonance;
- le deuxième photodétecteur est configuré pour détecter tout ou partie du deuxième faisceau lumineux ($F'_2$) s'étant propagé le long du résonateur, de façon que le signal de correction est établi à partir d'une composante basse fréquence du deuxième faisceau lumineux.

12. Oscillateur selon la revendication 11, dans lequel le circuit de traitement comporte un séparateur ($50_s$), configuré pour :

- diriger tout ou partie du premier faisceau ($F'_1$) vers le premier photodétecteur ;
- diriger tout ou partie du deuxième faisceau ($F'_2$) vers le deuxième photodétecteur.

13. Oscillateur selon l'une quelconque des revendications 11 ou 12, comportant :

- une voie optique (48), s'étendant entre la deuxième source de lumière et le circuit de traitement; la voie optique étant configurée pour transporter une partie du deuxième faisceau de lumière ($F_2$) de la source de lumière vers le circuit de traitement;
- un interféromètre ($40_i$), configuré pour former un signal d'interférence entre :

• le deuxième faisceau s'étant propagé le long du résonateur ;
• la partie du deuxième faisceau de lumière débouchant de la voie optique ;

- le circuit de traitement étant tel que le deuxième photodétecteur est configuré pour détecter le signal d'interférence résultant de l'interféromètre .

14. Oscillateur selon l'une quelconque des revendications 11 à 13, si référées à la revendication 10, dans lequel le guide d'onde est configuré pour recevoir le deuxième faisceau de lumière et propager ce dernier le long du résonateur, vers le circuit de traitement.

15. Oscillateur selon l'une quelconque des revendications précédentes, comportant un filtre passe haut (43), disposé entre le premier photodétecteur et le résonateur, et dont la fréquence de coupure est inférieure ou égale à la fréquence de résonance.

21  F
20
22

31

**Fig. 1A**

40
22
$S_{out}$

21
20
22

30

33

34

35

**Fig 1B**

**Fig. 2A**

**Fig. 2B**

**Fig. 3A**

**Fig. 3B**

**Fig. 3C**

**Fig. 3D**

**Fig. 4**

**Fig. 5A**

**Fig. 5B**

**Fig. 5C**

**Fig. 5D**

Europäisches
Patentamt

European
Patent Office

Office européen
des brevets

## RAPPORT DE RECHERCHE EUROPEENNE

**Numéro de la demande**

EP 24 22 2697

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2017/314973 A1 (LEONCINO LUCA [FR] ET AL) 2 novembre 2017 (2017-11-02) * figure 3 * | 1-15 | INV. H03B17/00 H03B5/04 |
| A | EP 3 698 465 B1 (THALES SA [FR]; CENTRE NAT RECH SCIENT [FR]; UNIV PARIS [FR]) 22 septembre 2021 (2021-09-22) * figure 5 * | 1-15 | |

**DOMAINES TECHNIQUES RECHERCHES (IPC)**

H03B

Le présent rapport a été établi pour toutes les revendications

| Lieu de la recherche | Date d'achèvement de la recherche | Examinateur |
|---|---|---|
| Munich | 16 mai 2025 | Schnabel, Florian |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 22 2697

16-05-2025

| Document brevet cité au rapport de recherche | Date de publication | Membre(s) de la famille de brevet(s) | Date de publication |
|---|---|---|---|
| US 2017314973 A1 | 02-11-2017 | EP 3244169 A1 | 15-11-2017 |
| | | FR 3050820 A1 | 03-11-2017 |
| | | US 2017314973 A1 | 02-11-2017 |
| EP 3698465 B1 | 22-09-2021 | CN 111684714 A | 18-09-2020 |
| | | EP 3698465 A1 | 26-08-2020 |
| | | EP 3698466 A1 | 26-08-2020 |
| | | FR 3072512 A1 | 19-04-2019 |
| | | US 2021058033 A1 | 25-02-2021 |
| | | WO 2019076983 A1 | 25-04-2019 |
| | | WO 2019077005 A1 | 25-04-2019 |

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **XU et al.** *Ultra-sensitive chip-based photonic température sensor using ring resonator structures*
- **LEE et al.** *Low jitter and température stable MEMS oscillators*
- **HUANG et al.** *Direct stabilization of optomechanical oscillators*, 2017
- **GAVARTIN**. *Stabilization of a linear nanomechanical oscillator to its thermodynamic limit*, 2013